# FASCICULE DE BREVET EUROPEEN

(11) **EP 0 750 397 B1**
(45) Date de publication et mention de la délivrance du brevet: **27.12.2000**
(21) Numéro de dépôt: 96470010.8
(22) Date de dépôt: 17.06.1996
(51) Int. Cl.: H03K 17/693

(54) **Circuit de commutation permettant de fournir sélectivement des tensions de signes différents**
Schaltkreis zur selektiven Auswahl von Spannungen verschiedener Vorzeichen
Switching circuit for selectively providing voltages of opposed signs

(30) Priorité: 21.06.1995 FR 9507620
(43) Date de publication de la demande: 27.12.1996
(73) Titulaire: STMicroelectronics S.A., 94250 Gentilly (FR)
(72) Inventeur: Guedj, Marc, 57000 Metz (FR); Brigati, Alessandro, 57000 Metz (FR); Aulas, Maxence, 57000 Metz (FR); Demange, Nicolas, 57000 Metz (FR)
(74) Mandataire: Schmit, Christian Norbert Marie

(56) Documents cités:
- GB-A- 2 065 404
- US-A- 3 330 968
- US-A- 3 602 738
- US-A- 4 742 492
- US-A- 4 945 267
- US-A- 5 077 691
- US-A- 5 334 881
- US-A- 5 399 917

## Description

L'invention concerne un circuit de commutation permettant de fournir sélectivement des tensions de signes différents.

On voit actuellement se développer dans des circuits intégrés l'utilisation de circuits d'alimentation délivrant des tensions de signes opposés pour alimenter sélectivement un même circuit. Ainsi, par exemple, le brevet US - 5 077 691 décrit une mémoire EEPROM de type flash dans laquelle on polarise des grilles de commande de transistors de mémorisation soit positivement, soit négativement, les tensions de polarisation étant produites par des circuits de type pompe de charge. Dans un tel contexte, il est préférable, pour diminuer le temps de polarisation des transistors, de produire en permanence les tensions de polarisation, et d'utiliser un circuit de commutation permettant de fournir sélectivement sur une sortie l'une des tensions tout en assurant un isolement entre les circuits d'alimentation. Le brevet US-A-4 745 492 divulgue un circuit de commutation, pour une mémoire EEPROM, selon le préambule de la revendication 1.

Ainsi, l'invention concerne un circuit de commutation comprenant les caractéristiques définies dans la revendication 1.

D'autres particularités et avantages apparaîtront à la lecture de la description qui suit, à lire conjointement aux dessins annexés dans lesquels :
- la figure 1 représente schématiquement un premier circuit selon l'invention,
- la figure 2 représente schématiquement une cellule de pompage utilisée dans l'invention,
- les figures 3a et 3b représentent des chronogrammes de signaux de pilotage d'une cellule de pompage utilisée dans l'invention,
- la figure 4 représente les moyens d'isolation utilisés dans l'invention,
- la figure 5 représente schématiquement un troisième circuit selon l'invention.

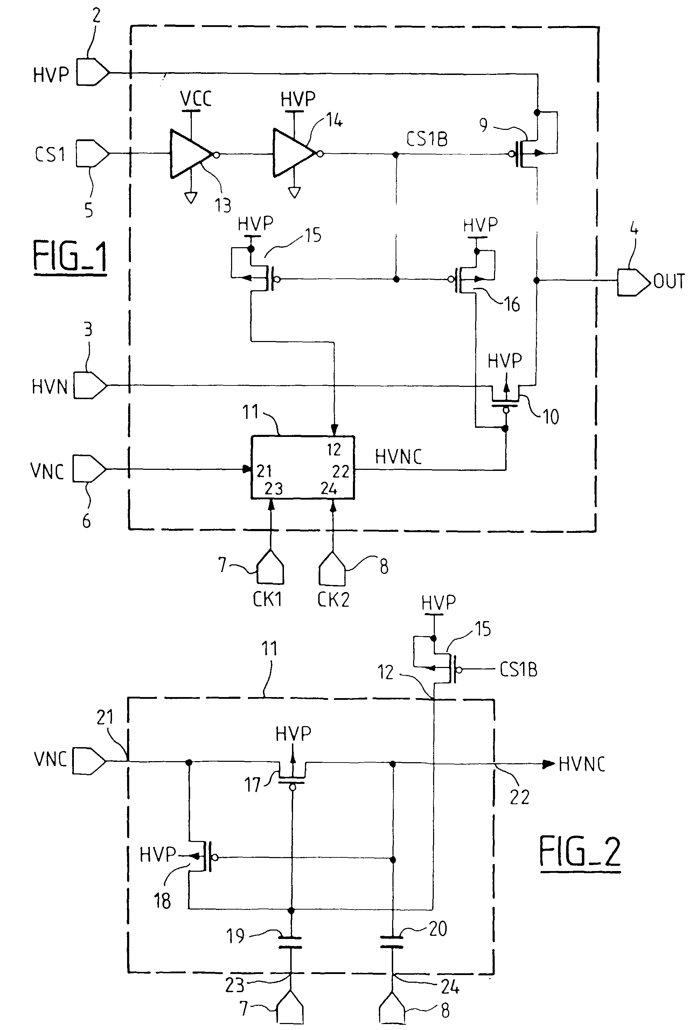

La figure 1 illustre schématiquement un circuit de commutation 1 réalisé conformément à l'invention.

Ce circuit 1 comprend :
- une première borne d'entrée 2 pour recevoir une tension positive HVP, produite par exemple par un générateur de tension de type pompe de charge à partir d'une tension d'alimentation VCC,
- une deuxième borne d'entrée 3 pour recevoir une tension négative HVN, produite par exemple par un générateur de tension de type pompe de charge à partir de la tension d'alimentation VCC,
- une borne de sortie 4 pour fournir une tension de sortie OUT,
- une borne d'entrée de commande 5 pour recevoir un signal logique de commande CS1,
- des moyens de commande et d'isolement (décrits ci-dessous) tels que la borne de sortie 4 soit reliée à la borne d'entrée 2 quand le signal CS1 et dans un premier état (CS1 = 0), que la borne de sortie 4 soit reliée à la borne d'entrée 3 quand le signal CS1 est dans un second état (CS1 = 1), et que les bornes d'entrée 2 et 3 soient isolées l'une de l'autre quel que soit l'état du signal de commande CS1.

Dans la suite de la description, on supposera que les circuits décrits sont réalisés de manière classique en technologie MOS à partir d'un substrat de type P. L'invention pourra typiquement être mise en oeuvre dans un circuit intégré, mais on pourra tout aussi bien la réaliser à l'aide de composants discrets.

La borne d'entrée 2 est reliée à la borne de sortie 4 par un transistor 9 de type P dont la source est reliée à la borne d'entrée 2, et dont le drain est relié à la borne de sortie 4. La grille de commande du transistor 9 reçoit un signal de commande CS1B de sorte que ce transistor 9 est passant ou bloqué selon l'état du signal CS1B, l'état du signal CS1B étant fonction de l'état du signal CS1. Le caisson du transistor 9 est relié à sa source afin de le polariser positivement.

La borne d'entrée 3 est reliée à la borne de sortie 4 par un transistor 10 de type P dont la source est reliée à la borne d'entrée 3 et dont le drain est relié à la borne de sortie 4. La grille de commande du transistor 10 reçoit un signal de commande HVNC de sorte que ce transistor est passant ou bloqué selon l'état du signal HVNC. Le caisson du transistor 10 est polarisé positivement, par exemple en le reliant à la borne d'entrée 2.

En supposant que la tension HVP est supérieure à VCC, on produit le signal CS1B à partir d'un élévateur de tension formé par exemple de deux inverseurs 13 et 14 montés en série entre la borne d'entrée de commande 5 et la grille de commande du transistor 9. Le premier inverseur 13 est alimenté entre la tension d'alimentation VCC et une masse, et le deuxième inverseur 14 est alimenté entre la tension HVP et la masse. Ainsi, si CS1 est à VCC (CS1 = 1), on a CS1B à HVP (CS1B = 1), et on a alors OUT = HVN. Si CS1 est à 0 volts (CS1 = 0), on a CS1B à 0 volts (CS1B = 0), et on a alors OUT = HVP. Bien entendu, on se passera des inverseurs 13 et 14 si on a HVP ≤ VCC. On remarquera que la tension HVP pourra être variable. Ainsi, on pourra très bien avoir HVP > VCC quand on a CS1 = 0 et HVP < VCC quand CS1 = 1.

On produit le signal HVNC à partir d'une cellule de pompage 11, décrite ci-dessous, qui reçoit une tension négative VNC présente sur une borne d'entrée 6 du circuit 1 et qui produit à partir de celle-ci la tension HVNC de sorte que cette dernière ait une valeur absolue supérieure à celle de HVN. La borne d'entrée 6 pourra être confondue avec la borne d'entrée 3, auquel cas on aura VNC = HVN.

La cellule de pompage 11, illustrée sur la figure 2, comprend :
- une entrée 21 pour recevoir la tension VNC,
- une sortie 22 pour fournir la tension HVNC, et
- deux entrées 23 et 24 pour recevoir des signaux d'horloge CK1 et CK2 reçus sur des borne d'entrée 7 et 8 du circuit 1.

La cellule 11 illustrée figure 2 comprend :
- un premier transistor 17 de type P dont la source est reliée à la borne d'entrée 21 et dont le drain est relié à la sortie 22,
- un deuxième transistor 18 de type P dont le drain est relié à l'entrée 21, dont la source est reliée à la grille de commande du premier transistor 17, et dont la grille de commande est reliée à la sortie 22,
- une première capacité 19 dont un premier pôle est relié à la grille de commande du transistor 17, et dont le deuxième pôle est relié à l'entrée 23,
- une deuxième capacité 20 dont un premier pôle est relié à la sortie 22, et dont le deuxième pôle est relié à l'entrée 24.

En pratique, les capacités 19 et 20 seront réalisées par exemple à l'aide de transistors de type P, le premier pôle de ces capacités correspondant à une grille de commande et le deuxième pôle correspondant à un drain et une source reliés entre eux. Le premier pôle de la capacité 19 est relié à une entrée 12 de la cellule 11.

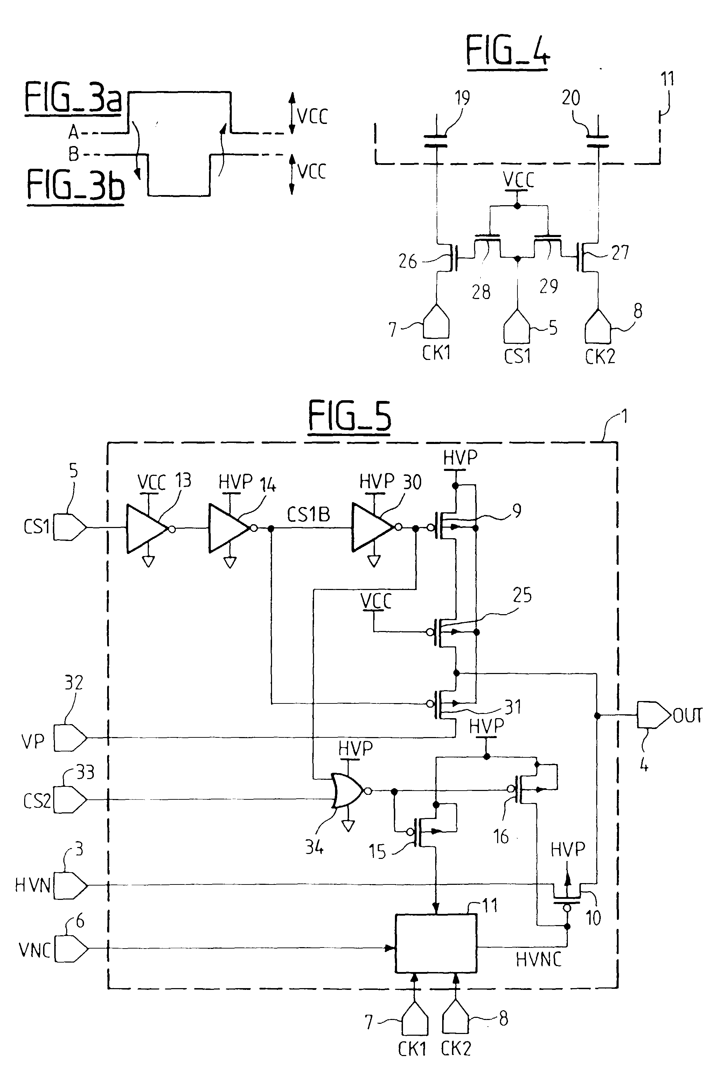

Les signaux CK1 et CK2 seront par exemple respectivement les signaux A et B illustrés figures 3a et 3b, ces signaux commutant entre VCC et 0 volts.

En supposant que le signal A est initialement à 0 et que le signal B est initialement à VCC, les signaux A et B sont tels que :
- la montée à VCC du signal A entraîne la descente à 0 du signal B,
- la montée à VCC du signal B entraîne la descente à 0 du signal A, ce signal A remontant postérieurement à VCC et ainsi de suite.

Dans la cellule 11, les charges négatives sont transférées de l'entrée 21 sur front descendant du signal A, le transistor 17 étant alors passant. Sur front montant de ce signal A le transistor 17 est bloqué. Sur front descendant du signal B, la tension de sortie HVNC augmente en valeur absolue de VCC.

Les caissons des transistors de type P de la cellule de pompage 11 sont polarisés positivement. Ils sont par exemple reliés par des moyens conducteurs non représentés (par exemple une ligne conductrice réalisée sur une couche métallique du circuit) à la borne d'entrée 2 pour recevoir la tension HVP.

Le circuit 1 comprend deux transistors 15 et 16 de type P dont les sources et les caissons sont reliés à la borne d'entrée 2, et dont les grilles de commande reçoivent le signal CS1B. Ces transistors ont pour fonction d'isoler les bornes d'entrée 3 et 6 de la borne de sortie 4 quand on souhaite fournir sur la borne de sortie 4 la tension positive HVP (CS1 = 0). Le drain du transistor 15 est relié à l'entrée 12 de la cellule 11. Le drain du transistor 16 est relié à la grille de commande du transistor 10. Quand CS1B = 0, on bloque les transistors 10 et 17 en imposant une tension positive (HVP dans l'exemple décrit) sur leurs grilles de commande. On a alors OUT = HVP. Quand CS1B = 1, on a OUT = HVN. Les bornes 2 et 4 sont alors isolées l'une de l'autre par le transistor 9 dont la grille de commande est à un potentiel supérieur ou égal aux potentiels présents sur son drain et sa source.

La figure 4 représente schématiquement les moyens d'isolation du circuit de commutation réalisé selon l'invention. Outre les éléments décrits en relation avec la figure 1 et non représentés sur la figure 4, on prévoit des moyens permettant d'isoler les entrées 23 et 24 de la cellule 11 des bornes d'entrée 7 et 8 du circuit quand on a CS1 = 0 (c'est à dire quand OUT = HVP).

Sur la figure 4 on intercale entre la borne d'entrée 7 du circuit et l'entrée 23 de la cellule 11 un transistor d'isolement 26 de type N. Ce transistor d'isolement 26 a son drain relié à l'entrée 23 et sa source reliée à la borne d'entrée 7. La grille de commande du transistor d'isolement 26 est relié à la borne d'entrée de commande 5 par le biais d'un transistor 28 dont la grille de commande est polarisée à VCC, dont la source est reliée à la borne d'entrée 5 et dont le drain est relié à la grille de commande du transistor 26.

On intercale entre la borne d'entrée 8 du circuit et l'entrée 24 de la cellule 11 un transistor d'isolement 27 de type N. Ce transistor d'isolement 27 a son drain relié à l'entrée 24 et sa source reliée à la borne d'entrée 8. La grille de commande du transistor d'isolement 27 est relié à la borne d'entrée de commande 5 par le biais d'un transistor 29 dont la grille de commande est polarisée à VCC, dont la source est reliée à la borne d'entrée 5 et dont le drain est relié à la grille de commande du transistor 27.

Le montage décrit en référence à la figure 4 permet d'isoler les deuxièmes pôles des capacités 19 et 20 des bornes d'entrée 7 et 8 quand on commande le circuit de commutation de telle sorte qu'il fournit sur la borne de sortie 4 la tension HVP. Ce montage présente plusieurs avantages. Il permet d'éviter de perturber (par pompage) la tension positive appliquée aux grilles de commande des transistors 10 et 17 pour isoler les bornes d'entrée 3 et 6 de la borne de sortie 4, ce qui est préférable si cette tension positive est la tension HVP. On pourrait arriver au même résultat en maintenant les signaux CK1 et CK2 dans un état constant. Cette solution peut s'envisager si ces signaux sont produits dans le seul but de cadencer le fonctionnement d'une cellule 11 d'un seul circuit de commutation mais sort du cadre de la présente invention. Si on souhaite par exemple utiliser deux circuits de commutation, de telle sorte qu'on fournisse une tension positive sur la borne de sortie d'un des circuits et une tension négative sur la borne de sortie de l'autre circuit, on ne pourra pas utiliser des signaux de cadencement identiques pour cadencer le fonctionnement de leurs cellules de pompage (ce qui implique de dupliquer les circuits de production de ces signaux et pose un problème d'encombrement). Le montage illustré sur le figure 4 présente l'avantage de permettre, dans l'hypothèse présentée ci-dessus, l'utilisation de signaux de cadencement identiques. On peut ainsi produire les signaux illustrés sur les figures 3a et 3b de manière répétitive, indépendamment des tensions à fournir sur les bornes de sortie des circuits de commutation, sans perturber la tension HVP.

La figure 5 représente un circuit de commutation selon l'invention, dans lequel on prévoit de fournir sélectivement sur la borne de sortie 4 une troisième tension positive notée VP, inférieure à HVP.

Dans le circuit illustré sur la figure 5, outre les éléments représentés à la figure 1 (et portant des références identiques), le circuit 1 comprend un transistor 31 de type P. Ce transistor 31 a son drain relié à la borne de sortie 4. Sa source est reliée à une borne d'entrée 32 recevant une tension positive VP. Sa grille de commande est reliée à la sortie de l'inverseur 14. Enfin on intercale un inverseur 30 entre la sortie de l'inverseur 14 et la grille de commande du transistor 9. D'autre part, le drain de ce transistor 9 est relié à la borne de sortie 4 par le biais d'un transistor d'isolement 25 de type P. La source du transistor 25 est reliée au drain du transistor 9, et son drain est relié à la borne de sortie 4. On polarise positivement les caissons des transistors 25 et 31, par exemple en les reliant à la source du transistor 9. La grille de commande du transistor 25 est polarisée positivement à une tension positive inférieure à HVP.

Le circuit de la figure 5 comprend enfin une porte logique NON_OU 34. Cette porte 34, alimentée entre la tension HVP et la masse, reçoit le signal complémentaire de CS1B sur une première entrée (ce signal étant fourni en sortie de l'inverseur 30). Il a une deuxième entrée reliée à une borne d'entrée 33 du circuit, celle-ci recevant un signal logique de commande CS2. Sa sortie est reliée aux grilles de commande des transistors 15 et 16. Les transistors 15 et 16 ne sont donc plus commandés directement par l'inverseur 14.

Dans le montage illustré sur la figure 5, on relie la borne de sortie 4 à :
- la borne d'entrée 3 si CS1 est à VCC (CS1 = 1) et CS2 est à 0 volts (CS2 = 0),
- la borne d'entrée 2 si CS1 et CS2 sont à VCC (CS2 = CS1 = 1),
- la borne d'entrée 32 si CS1 est à 0 volts (CS1 = 0) et si CS2 est à VCC (CS2 = 1).

Dans le premier cas (OUT = HVN), les transistors 15 et 16 sont bloqués, ce qui permet de relier les bornes 3 et 4. Le transistor 31 est bloqué, ce qui isole la borne d'entrée 32 du reste du circuit. Enfin, le transistor 9 est passant mais le transistor 25 est bloqué, ce qui isole la borne d'entrée 2 de la borne de sortie 4. On remarquera que l'on aurait aussi pu placer le transistor 25 entre la borne de sortie 4 et le transistor 31, la grille de commande de ce dernier transistor étant alors reliée à la sortie de l'inverseur 30 et la grille de commande du transistor 9 étant reliée à la sortie de l'inverseur 14. Dans ce cas, pour OUT = HVN, on isole la borne d'entrée 2 en bloquant le transistor 9, et on isole la borne d'entrée 32 avec le transistor 25. On prendra soin, dans cette configuration, de polariser la grille de commande du transistor 25 à une tension inférieure à VP (ce qui impose qu'on produise une tension supplémentaire).

Dans les autres cas (OUT différent de HVN), les transistors 15 et 16 sont passants, et la borne d'entrée 3 est isolée du reste du circuit.

Dans le second cas (OUT = HVP), le transistor 31 isole la borne d'entrée 32 du reste du circuit (ou la borne d'entrée 2 du reste du circuit si le transistor 25 est placé entre la borne de sortie 4 et la borne d'entrée 32, OUT étant alors égale à VP).

Enfin, dans le dernier cas (OUT = VP), la borne d'entrée 2 (ou la borne d'entrée 32, si OUT = HVP) est isolée de la borne de sortie, le transistor 9 (ou le transistor 31) étant bloqué.

Bien entendu, on se passera des inverseurs 13 et 14 si on a HVP ≤ VCC. Dans ce cas, la grille de commande du transistor d'isolement 25 ne recevra pas la tension VCC tel qu'il est montré sur la figure 5, mais une tension différente inférieure à HVP (et supérieure à VP). On remarquera que la tension HVP pourra être variable. Ainsi, on pourra très bien avoir HVP > VCC quand on a CS1 = 0 et HVP < VCC quand CS1 = 1.

Le circuit tel qu'il est illustré figure 5 est particulièrement intéressant pour polariser des grilles de commande de transistors à grille flottante de mémoires EEPROM de type flash, une tendance étant d'imposer sur ces grilles des tensions élevées positives ou négatives lors d'opérations d'effacement et d'écriture, et une tension positive faible lors d'opérations de lecture.

Bien qu'on ne l'ait pas représenté sur la figure 5, le circuit représenté à la figure 5 est mis en oeuvre conformément à ce qui a été décrit en référence à la figure 4.

## Revendications

1. Circuit de commutation comprenant une première borne d'entrée (2) pour recevoir une première tension positive (HVP), une deuxième borne d'entrée (3) pour recevoir une tension négative (HVN), une première borne d'entrée de commande (5) pour recevoir un premier signal logique de commande (CS1), une borne de sortie (4) pour fournir une tension de sortie (OUT) en reliant sélectivement cette borne de sortie (4) à l'une des bornes d'entrée (2, 3), les première et deuxième bornes d'entrée étant respectivement reliées à la borne de sortie par le biais d'un premier et d'un deuxième transistors (9, 10), des moyens de commande (11, 13, 14, 15, 16) pour produire, en fonction du signal de commande (CS1), des tensions de commande (CS1B, HVNC) appliquées aux grilles de commande des transistors (9, 10) pour relier sélectivement la borne de sortie (4) à l'une des bornes d'entrée (2, 3), et une cellule de pompage (11) pour produire une tension de commande (HVNC) appliquée à la grille de commande du deuxième transistor (10)
le circuit étant caractérisé en ce que le fonctionnement de la cellule de pompage (11) est cadencé par des signaux d'horloge (CK1, CK2) reçus par le circuit sur des quatrième et cinquième bornes d'entrée (7, 8), et
en ce qu'il comprend des moyens (26-29) pour isoler la cellule de pompage (11) des quatrième et cinquième bornes d'entrée (7, 8) quand la grille de commande du deuxième transistor (10) est polarisée positivement afin de le bloquer.

2. Circuit selon la revendication 1, caractérisé en ce qu'il comprend une troisième borne d'entrée (32) pour recevoir une deuxième tension positive (VP), cette troisième borne d'entrée (32) étant reliée à la borne de sortie (4) par le biais d'un troisième transistor (31), une deuxième borne d'entrée de commande (33) pour recevoir un deuxième signal logique de commande (CS2), les moyens de commande (11, 13, 14, 15, 16, 30, 34) produisant, en fonction des signaux de commande (CS1, CS2), des tensions de commande appliquées aux grilles de commande des transistors (9, 10, 31) pour relier sélectivement la borne de sortie (4) à l'une des bornes d'entrée (2, 3, 32).

3. Circuit selon la revendication 2, caractérisé en ce que les grilles de commande des premier et troisième transistors (9, 31) sont commandées par des tensions de commande complémentaires et en ce le circuit comprend un transistor d'isolement (25) pour isoler le premier ou le troisième transistor (9, 31) de la borne de sortie (4) quand celle ci est reliée à la deuxième borne d'entrée (3).

4. Circuit selon l'une des revendications 1 à 3, caractérisé en ce que la tension de commande appliquée à la grille de commande du premier transistor (9) est produite par un circuit (13, 14, 30) élévateur de tension.

5. Circuit selon l'une des revendications 1 à 4, caractérisé en ce qu'il comprend des moyens (16) pour polariser positivement la grille de commande du deuxième transistor(10) quand le premier transistor (9) est passant.

6. Circuit selon l'une des revendications 2 à 5, caractérisé en ce qu'il comprend des moyens (16, 34) pour polariser positivement la grille de commande du deuxième transistor (10) quand le troisième transistor (31) est passant.

## Patentansprüche

1. Schaltkreis mit einer ersten Eingangsklemme (2), um eine erste positive Spannung (HVP) zu empfangen, einer zweiten Eingangsklemme (3), um eine negative Spannung (HVN) zu empfangen, einer ersten Steuereingangsklemme (5), um ein erstes logisches Steuersignal (CS1) zu empfangen, einer Ausgangsklemme (4), um eine Ausgangsspannung (OUT) zu liefern, indem selektiv diese Ausgangsklemme (4) mit einer der Eingangsklemmen (2, 3) verbunden wird, wobei die erste und die zweite Eingangsklemme mit der Ausgangsklemme je über einen ersten bzw. einen zweiten Transistor (9, 10) verbunden sind, mit Steuereinrichtungen (11, 13, 14, 15, 16), um in Abhängigkeit vom Steuersignal (CS1) Steuerspannungen (CS1B, HVNC) zu erzeugen, die an die Steuergates der Transistoren (9, 10) angelegt werden, um selektiv die Ausgangsklemme (4) mit einer der Eingangsklemmen (2, 3) zu verbinden, und mit einer Pumpzelle (11), um eine Steuerspannung (HVNC) zu erzeugen, die an das Steuergate des zweiten Transistors (10) angelegt wird, wobei der Schaltkreis dadurch gekennzeichnet ist, daß der Betrieb der Pumpzelle (11) von Taktsignalen (CK1, CK2) getaktet wird, die vom Schaltkreis an vierten und fünften Eingangsklemmen (7, 8) empfangen werden, und daß er Einrichtungen (26, 29) aufweist, um die Pumpzelle (11) von den vierten und fünften Eingangsklemmen (7, 8) zu isolieren, wenn das Steuergate des zweiten Transistors (10) positiv vorgespannt ist, um ihn zu sperren.

2. Schaltkreis nach Anspruch 1, dadurch gekennzeichnet, daß er eine dritte Eingangsklemme (32), um eine zweite positive Spannung (VP) zu empfangen, wobei diese dritte Eingangsklemme (32) mit der Ausgangsklemme (4) über einen dritten Transistor (31) verbunden ist, und eine zweite Steuereingangsklemme (33) aufweist, um ein zweites logisches Steuersignal (CS2) zu empfangen, wobei Steuereinrichtungen (11, 13, 14, 15, 16, 30, 34) in Abhängigkeit von den Steuersignalen (CS1, CS2) Steuerspannungen erzeugen, die an die Steuergates der Transistoren (9, 10, 31) angelegt werden, um selektiv die Ausgangsklemme (4) mit einer der Eingangsklemmen (2, 3, 32) zu verbinden.

3. Schaltkreis nach Anspruch 2, dadurch gekennzeichnet, daß die Steuergates des ersten und des dritten Transistors (9, 31) von komplementären Steuerspannungen gesteuert werden, und daß der Schaltkreis einen Isoliertransistor (25) aufweist, um den ersten oder den dritten Transistor (9, 31) von der Ausgangsklemme (4) zu isolieren, wenn diese mit der zweiten Eingangsklemme (3) verbunden ist.

4. Schaltkreis nach einem der Ansprüche 1 bis 3, dadurch gekennzeichnet, daß die an das Steuergate des ersten Transistors (9) angelegte Steuerspannung von einem Spannungserhöhungskreis (13, 14, 30) erzeugt wird.

5. Schaltkreis nach einem der Ansprüche 1 bis 4, dadurch gekennzeichnet, daß er Einrichtungen (16) aufweist, um das Steuergate des zweiten Transistors (10) positiv vorzuspannen, wenn der erste Transistor (9) leitend ist.

6. Schaltkreis nach einem der Ansprüche 2 bis 5, dadurch gekennzeichnet, daß er Einrichtungen (16, 34) aufweist, um das Steuergate des zweiten Transistors (10) positiv vorzuspannen, wenn der dritte Transistor (31) leitend ist.

## Claims

1. Switching circuit comprising a first input terminal (2) for receiving a first positive voltage (HVP), a second input terminal (3) for receiving a negative voltage (HVN), a first control input terminal (5) for receiving a first logic control signal (CS1), an output terminal (4) for supplying an output voltage (OUT) by selectively connecting this output terminal (4) to one of the input terminals (2, 3), the first and second input terminals being respectively connected to the output terminal by means of first and second transistors (9, 10), control means (11, 13, 14, 15, 16) for producing, according to the control signal (CS1), control voltages (CS1B, HVNC) applied to the control gates of the transistors (9, 10) by selectively connecting the output terminal (4) to one of the input terminals (2, 3), and a pumping cell (11) for producing a control voltage (HVNC) applied to the control gate of the second transistor (10)
the circuit being characterised in that functioning of the pumping cell (11) is timed by clock signals (CK1, CK2) received by the circuit at the fourth and fifth input terminals (7, 8), and
in that it comprises means (26) for isolating the pumping cell (11) from the fourth and fifth input terminals (7, 8) when the control gate of the second transistor (10) is positively biased in order to switch it off.

2. Circuit according to Claim 1, characterised in that it comprises a third input terminal (32) for receiving a second positive voltage (VP), this third input terminal (32) being connected to the output terminal (4) by means of a third transistor (31), a second control input terminal (33) for receiving a second logic control signal (CS2), the control means (11, 13, 14, 15, 16, 30, 34) producing, according to the control signals (CS1, CS2), control voltages applied to the control gates of the transistors (9, 10, 31) for selectively connecting the output terminal (4) to one of the input terminals (2, 3, 32).

3. Circuit according to Claim 2, characterised in that the control gates of the first and third transistors (9, 31) are controlled by complementary control voltages and in that the circuit comprises an isolating transistor (25) for isolating the first or third transistor (9, 31) from the output terminal (4) when the latter is connected to the second input terminal (3).

4. Circuit according to one of Claims 1 to 3, characterised in that the control voltage applied to the control gate of the first transistor (9) is produced by a voltage step-up circuit (13, 14, 30).

5. Circuit according to one of Claims 1 to 4, characterised in that it comprises means (16) for positively biasing the control gate of the second transistor (10) when the first transistor (9) is on.

6. Circuit according to one of Claims 2 to 5, characterised in that it comprises means (16, 34) for positively biasing the control gate of the second transistor (10) when the third transistor (31) is on.
